# EUROPEAN PATENT APPLICATION

(11) **EP 1 800 791 A1**
(43) Date of publication of application: **27.06.2007**
(21) Application number: 06256508.0
(22) Date of filing: 21.12.2006
(51) Int. Cl.: B23K 26/38, H05K 3/00

(54) **Method of forming via hole using laser beam**

(30) Priority: 21.12.2005 KR 20050126891
(71) Applicant: EO Technics Co., Ltd., Dongan-gu, Anyang-city Kyungki-do 431-062 (KR)
(72) Inventor: Seong, Cheon Ya, Dobong-gu Seoul 132-789 (KR); Cho, Kwang Woo, Songpa-gu Seoul 138-190 (KR); Kim, Seong Hoon, Ansan-City Kyungki-do 425-765 (KR); You, Choong Ki, Uiwang-City Kyungki-do 437-120 (KR)
(74) Representative: Pawlyn, Anthony Neil

(57) **Abstract**

Provided is a method of forming a via hole using a laser beam. The method includes forming a first hole in the first metal layer by irradiating a laser beam having a predetermined frequency; reducing an energy density of the laser beam having the same frequency; and forming a second hole corresponding to the first hole in the dielectric layer by irradiating the laser beam having the same frequency.

## Description

### CROSS-REFERENCE TO RELATED PATENT APPLICATION

This application claims the benefit of Korean Patent Application No. 10-2005-0126891, filed on December 21, 2005, in the Korean Intellectual Property Office, the disclosure of which is incorporated herein in its entirety by reference.

### BACKGROUND OF THE INVENTION

### 1. Field of the Invention

The present invention relates to a method of forming a via hole using a laser beam, and more particularly, to a method of sequentially removing a metal layer and a dielectric layer of a multilayer substrate repeatedly using the same frequency of a laser beam instead of using multiple frequency of the laser beam.

### 2. Description of the Related Art

Substrates for electronic circuits used in a semiconductor process have a structure in which an upper metal layer, a dielectric layer, and a lower metal layer are stacked. To electrically connect the upper metal layer to the lower metal layer, a hole (hereinafter a via hole) is formed in the upper metal layer and the dielectric layer and filled with a conductive metal. The via hole has a diameter, for example, of a few tens to a few hundreds of micrometers.

Techniques for processing a minute via hole are further required together with the development of semiconductor processing techniques since conventional mechanical methods cannot form via holes small enough in sizes for recent semiconductors.

For this reason, a method of forming a via hole using a laser beam has received attention. When using a laser beam, the formation of a hole in the lower metal layer must be prevented when a hole is formed in the dielectric layer after the hole is formed in the upper metal layer. Also, it is important to align the hole in the upper metal layer with the hole in the dielectric layer. The productivity of hole formation is also important.

### SUMMARY OF THE INVENTION

The present invention provides a method of forming a via hole using a laser beam, by which the precision and speed of removing a dielectric layer under a metal layer can be increased using the laser beam.

According to an aspect of the present invention, there is provided a method of forming a via hole using a laser beam in a multilayer substrate having a first metal layer, a dielectric layer formed under the first metal layer, and a second metal layer formed under the dielectric layer, the method comprising: forming a first hole in the first metal layer by irradiating a laser beam having a predetermined frequency; reducing an energy density of the laser beam having the same frequency; and forming a second hole corresponding to the first hole in the dielectric layer by irradiating the laser beam having the same frequency.

The irradiating of the laser beam may comprise using an energy density of the laser beam which is greater than a critical energy density required to remove the first metal layer.

According to the present invention, the reducing of the energy density may comprise reducing the energy density of the laser beam between the critical energy density required to remove the first metal layer and a critical energy density required to remove the dielectric layer.

According to an aspect of the present invention, the reducing of the energy density may comprise using an ND filter that reduces the energy of the laser beam by a predetermined ratio.

According to another aspect of the present invention, the reducing of the energy density may comprise increasing a rotation speed of a galvano scanner mirror of a laser generator to reduce the energy density of the laser beam per unit area of the dielectric layer.

According to still another aspect of the present invention, the reducing of the energy density may comprise defocusing the laser beam using f-theta lens on the dielectric layer.

### BRIEF DESCRIPTION OF THE DRAWINGS

The above and other features and advantages of the present invention will become more apparent by describing in detail exemplary embodiments thereof with reference to the attached drawings in which:
FIG. 1 is a schematic drawing showing the configuration of laser system applied to a method of forming a via hole using a laser beam according to an embodiment of the present invention;
FIG. 2 is a graph showing an output characteristic curve of a diode pumped solid state (DPSS) laser used in the present invention;
FIG. 3 is a drawing showing the relative locations of laser beams with respect to a target according to the energy density of the DPSS laser by adjusting a diode current;
FIGS. 4A through 4C are cross-sectional views illustrating a method of forming a via hole using a laser beam according to an embodiment of the present invention;
FIG. 5 is a perspective view illustrating the principle of operation of a galvano scanner of FIG. 1; and
FIG. 6 is a plan view illustrating a stepped ND filter having a rotation wheel 200 with a plurality of neutral density (ND) filters used to reduce the energy density of a laser beam.

### DETAILED DESCRIPTION OF THE INVENTION

A method of forming a via hole using a laser beam will now be described with reference to the accompanying drawings in which exemplary embodiments of the invention are shown. In the drawings, the thicknesses of layers and regions are exaggerated for clarity.

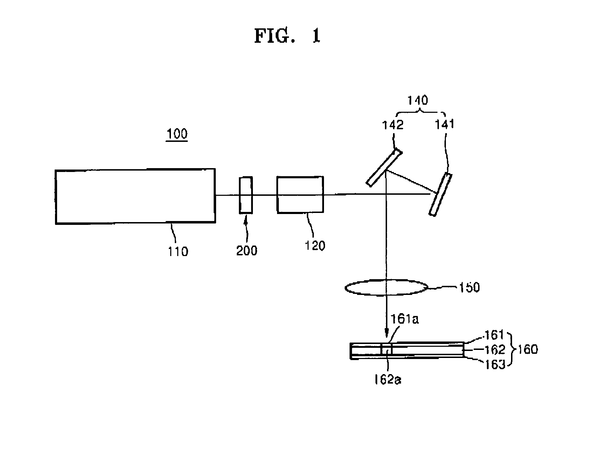

FIG. 1 is a schematic drawing showing the configuration of laser system applied to a method of forming a via hole using a laser beam according to an embodiment of the present invention.

Referring to FIG. 1, a laser beam generated from a laser generator 110 of a laser system 100 is expanded by a beam expander 120, then irradiated onto a multilayer substrate 160 through a galvano scanner 140 and an f-theta lens 150.

The multilayer substrate 160 includes a lower conductive layer 163 formed of a conductive metal, for example Cu, a dielectric layer 162 formed on the lower conductive layer 163, and an upper conductive layer 161 formed on the dielectric layer 162. The upper conductive layer 161 can also be formed of Cu. Reference 200 indicates a rotation wheel which will be described later.

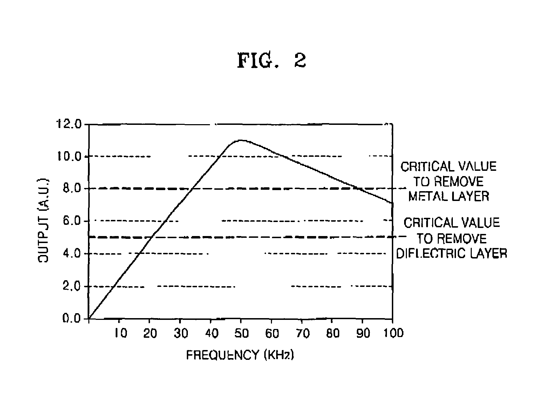

FIG. 2 is a graph showing an output characteristic curve of a diode pumped solid state (DPSS) laser used in the present invention. Referring to FIG. 2, an output of the laser beam is indicated as an arbitrary unit, and the energy density of a laser beam is highest at a frequency of approximately 50 kHz. If the critical energy density of a laser beam required to remove the upper conductive layer 161 of the multilayer substrate 160 is 8, and the critical energy density required to remove the dielectric layer 162 is 5, then as a first step, a laser beam having a laser energy density of 8 or more, for example a laser beam generated at a frequency of 40 ~ 80 kHz can be used to form a first hole 161 a in the upper conductive layer 161.

As a second step, a laser beam having a laser energy density of 5~8 at a frequency of approximately 20~35 kHz can be used to form a second hole 162a aligned with the first hole 161a in the dielectric layer 162.

However, when the first hole 161 a and the second hole 162a are respectively formed in the upper conductive layer 161 and the dielectric layer 162, it is difficult to form a precise via hole by controlling the frequency to control the energy density of the laser beam.

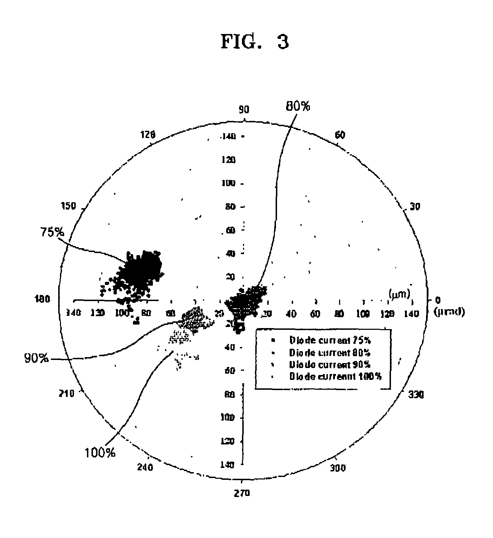

FIG. 3 is a drawing showing the relative locations of laser beams with respect to a target according to the energy density of the DPSS laser by adjusting a diode current.

Referring to FIG. 3, the laser beam of UV wavelengths from the DPSS laser was generated by changing a diode current to 75 to 100 % at a frequency of 35kHz. The output power of the laser beam changes with the diode current. FIG. 3 shows that as the output power of the laser beam changes, the position of the laser beam changes, causing a position error of the laser beam. The position error of the laser beam can make difficult the formation of a minute via hole comprising the first hole 161a and the second hole 162a.

In the present invention, to remove the position error of the laser beam due to the change of the diode current or the frequency, the upper conductive layer 161 and the dielectric layer 162 are removed using the same frequency and the same diode current.

In the present invention, the laser processing is done using higher frequency for the increase of laser processing speed instead of using the highest output power of the laser at a frequency, for example 50 kHz.

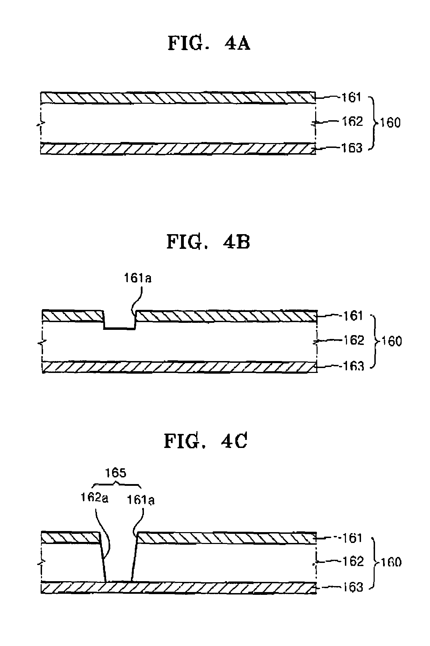

FIGS. 4A through 4C are cross-sectional views illustrating a method of forming a via hole using a laser beam according to an embodiment of the present invention.

Referring to FIG. 4A, a multilayer substrate 160 for forming a via hole includes an upper conductive layer 161, a dielectric layer 162, and a lower conductive layer 163. The upper conductive layer 161 and the lower conductive layer 163 can be formed of Cu. The dielectric layer 162 can be formed of a resin or FR4(flame resistant 4) material. A via hole is formed to electrically connect the upper conductive layer 161 to the lower conductive layer 163.

First, to process the upper conductive layer 161 of the multilayer substrate 160, the energy power of the DPSS laser is controlled to greater than the critical energy power required to remove the upper conductive layer 161, for example, Cu. Referring to FIG. 2, the frequency of the DPSS can be controlled between 40 kHZ to 80 kHz, preferably 70 - 80 kHz for increase of laser processing speed. Next, a first hole 161 a having a diameter of a few tens to a few hundreds of micrometers is formed in the upper conductive layer 161 by irradiating the laser beam for a predetermined time (first step). At this time, as shown in FIG. 4B, a portion of the dielectric layer 162 can be removed together with the upper conductive layer 161.

Next, the energy power density of the laser beam is controlled to greater than the critical energy density required to remove the dielectric layer 162, by using an energy density reducing element (second step).

Next, a via hole 165 of Fig. 4C is formed by forming a second hole 162a corresponding to the first hole 161 a in the dielectric layer 162 using a laser beam generated from a laser having the same frequency, for example, 70 kHz as in the first step (third step).

To reduce the energy density of the laser beam, a line speed of a galvano scanner can be increased, or an ND filter which reduces light transmittance can be used. The method of reducing the energy density of the laser beam will be described later.

In the method of forming a via hole using a laser beam according to an embodiment of the present invention, unlike the prior art, the first and third steps use the same high frequency and the same power of a laser beam generated from the laser generator. Therefore, in the third step, the via hole 165 can be processed at a high speed. Also, the minute via hole 165 can be formed precisely, since the second hole 162a is correctly positioned under the first hole 161 a. Thus the present invention allows increased processing speed while also providing a precise via hole.

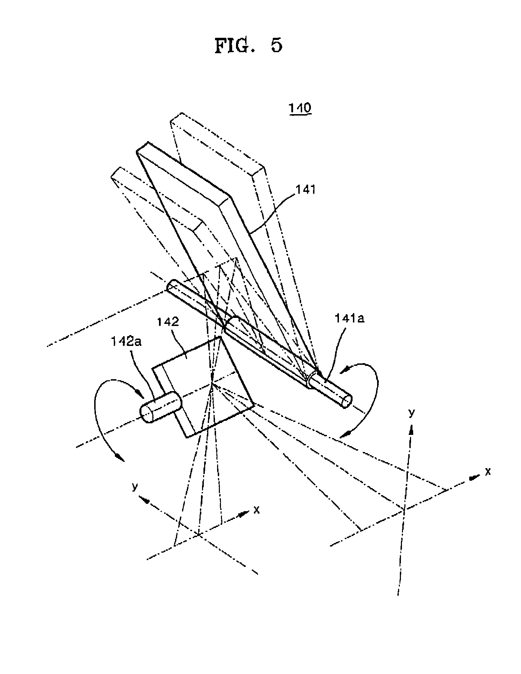

FIG. 5 is a perspective view illustrating the principle of operation of a galvano scanner 140 of FIG. 1. The galvano scanner 140 includes an x mirror 141 and a y mirror 142. The x mirror 141 controls a laser beam in an x direction using an x driver (not shown) that rotates a shaft 141 a connected to one side of the x mirror 141, and the y driver 142 controls a laser beam reflected from the x mirror 141 in a y direction using a y driver (not shown) that rotates a shaft 142a connected to one side of the y mirror 142. Accordingly, a laser beam generated from a laser generator can apply different energy densities to the multilayer substrate 160 according to the rotation speeds of the x and y mirrors 141 and 142 of the galvano scanner 140. In the third step, the energy density of the laser beam applied to the dielectric layer 162 can be reduced by increasing the rotation speed of the x and y mirrors 141 and 142 of the galvano scanner 140.

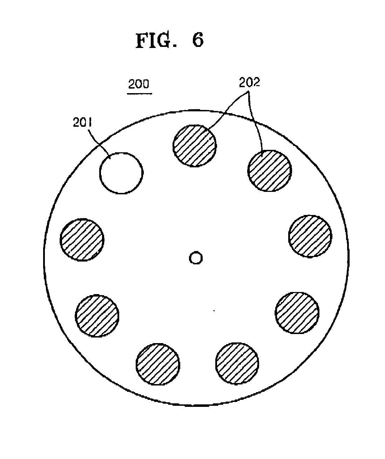

FIG. 6 is a plan view of a stepped ND filter having a rotation wheel 200 with a plurality of neutral density (ND) filters used for reducing the energy density of a laser beam. A plurality of holes 201 are formed in the rotation wheel 200. The holes 201 contain a plurality of ND filters 202 having a light transmittance of, for example, 10 to 60 %. There are also a vacant hole 201 that do not have ND filters 202 thereon. The rotation wheel 200 may be rotated by an actuator(not shown). The ND filters 202 can be used to reduce the energy density of the laser beam to a desired level. As depicted in FIG. 1, the rotation wheel 200 can be located between the laser beam generator 110 and the beam expander 120. In the first step, to form the first hole 161 a, the vacant hole 201 is used. In the third step, a hole having ND filter 202 is used to form the second hole 162a.

The ND filter 202 may be a reflective ND filter or an absorbent ND filter. Also a variable reflective ND filter having a changeable light transmittance according to a rotation angle may be used instead of the stepped ND filter.

The energy density per unit area of the multilayer substrate 160 can be reduced by increasing the spot size of the laser beam reaching the multilayer substrate 160. For this purpose, the focus of the f-theta lens 150 of FIG. 1 can be separated from the surface of the multilayer substrate 160.

Also, an acoustic-optic modulator having a variable light transmittance by an acoustic signal or an electro-optic modulator having a variable light transmittance by an elctrical field may be used for reducing energy density of the laser beam instead of the stepped ND filter.

The methods of reducing the energy density of the laser beam described above can be used separately or together.

As described above, according to the method of forming a via hole using a laser beam according to the present invention, the laser beam having the same high frequency and the same power generated from a laser generator is used in a first step and a third step. Therefore, in a third step, a dielectric layer can be processed at the same high speed as in the first step. Also, a precise via hole can be formed by precisely aligning the second via hole formed in the dielectric layer with the first via hole. Thus, the method of forming a via hole using a laser beam according to the present invention can not only increase the speed of processing a via hole, but also form a precise via hole.

While the present invention has been particularly shown and described with reference to exemplary embodiments thereof, it will be understood by those of ordinary skill in the art that various changes in form and detail may be made therein without departing from the spirit and scope of the present invention as defined by the following claims.

## Claims

1. A method of forming a via hole using a laser beam in a multilayer substrate having a first metal layer, a dielectric layer formed under the first metal layer, and a second metal layer formed under the dielectric layer, the method comprising:
forming a first hole in the first metal layer by irradiating a laser beam having a predetermined frequency:
reducing an energy density of the laser beam having the same frequency; and
forming a second hole corresponding to the first hole in the dielectric layer by irradiating the laser beam having the same frequency.

2. The method of claim 1, wherein the irradiating of the laser beam comprising using an energy density of the laser beam which is greater than a critical energy density required to remove the first metal layer.

3. The method of claim 1, wherein the reducing of the energy density comprises reducing the energy density of the laser beam between the critical energy density required to remove the first metal layer and a critical energy density required to remove the dielectric layer.

4. The method of claim 1, wherein the reducing of the energy density comprises using an ND filter that reduces the energy of the laser beam by a predetermined ratio.

5. The method of claim 4, wherein the ND filter is a reflective ND filter or an absorbent ND filter.

6. The method of claim 4, wherein the ND filter is a stepped ND filter comprising a rotation wheel having a plurality of holes and a plurality of NF filter on the plurality of hole.

7. The method of claim 4, wherein the ND filter is a variable reflective ND filter having a changeable light transmittance accorting to a rotation angle.

8. The method of claim 1, wherein the reducing of the energy density comprises using an acoustic-optic modulator having a variable light transmittance by an acoustic signal or an electro-optic modulator having a variable light transmittance by an elctrical field for reducing energy density of the laser beam.

9. The method of claim 1, wherein the reducing of the energy density comprises increasing a rotation speed of a galvano scanner mirror of a laser generator to reduce the energy density of the laser beam at the dielectric layer.

10. The method of claim 4, wherein the reducing of the energy density comprises using the ND fitter and increasing a rotation speed of a galvano scanner mirror of a laser generator to reduce the energy density of the laser beam at the dielectric layer.

11. The method of claim 1, wherein the reducing of the energy density comprises defocusing the laser beam using an f-theta lens on the dielectric layer.

12. The method of claim 4, wherein the reducing of the energy density comprises using the ND filter and defocusing the laser beam using an f-theta lens on the dielectric layer.

13. The method of claim 10, wherein the reducing of the energy density comprises using the ND filter and increasing the rotation speed of the galvano scanner mirror of the laser generator and defocusing the laser beam using an f-theta lens on the dielectric layer.
